# FASCICULE DE BREVET EUROPEEN

(11) **EP 1 434 270 B1**
(45) Date de publication et mention de la délivrance du brevet: **09.08.2006**
(21) Numéro de dépôt: 03104193.2
(22) Date de dépôt: 14.11.2003
(51) Int. Cl.: H01L 27/146

(54) **Dispositif de détection photo-électrique et procédé pour sa réalisation**
Fotoelektrische Sensoranordnung und Herstellungsverfahren dafür
Photo-electric sensor device and method for making same

(30) Priorité: 29.11.2002 FR 0215023
(43) Date de publication de la demande: 30.06.2004
(73) Titulaire: COMMISSARIAT A L'ENERGIE ATOMIQUE, 75752 Paris Cédex 15 (FR)
(72) Inventeur: Moussy, Norbert, 38190, SAINTE AGNES (FR); Guedj, Cyril, 38760, VARCES ALLIERES ET RISSET (FR)
(74) Mandataire: Vuillermoz, Bruno

(56) Documents cités:
- EP-A- 0 517 208
- EP-A- 1 122 790
- WO-A-02/50921

## Description

Le domaine de l'invention est celui des détecteurs optiques, comprenant classiquement une couche de détection associée à un circuit de lecture, notamment réalisé selon la structure dite *« above IC»,* c'est à dire sur circuit intégré, dans le domaine de la microélectronique.

Les détecteurs optiques sont classiquement destinés à détecter une intensité lumineuse, et à la transformer en un signal électrique, dont l'amplitude est proportionnelle à l'intensité lumineuse détectée. Ces signaux électriques sont généralement traités, notamment au niveau du circuit de lecture, afin de restituer une image de la scène détectée.

Dans un souci de miniaturisation de ces dispositifs de détection, on a cherché à intégrer la détection proprement dite avec le circuit de traitement du signal qui lui est associé.

Or le principe d'une structure « above IC » présente l'avantage de permettre d'aboutir à un facteur de remplissage en pixels de détection proche de 100 %, dans la mesure où le circuit de lecture est situé sous la couche de détection.

Traditionnellement, la couche de détection, interconnectée avec le circuit de lecture au travers d'un substrat isolant, est constituée de détecteurs élémentaires sous la forme d'une matrice. Chacun de ces détecteurs élémentaires comporte une électrode dite inférieure réalisée sur ledit substrat isolant, typiquement de la silice ou un nitrure de silicium, et reliée au circuit de lecture par le biais d'un conducteur électrique traditionnellement dénommé « plug » ou « via » traversant ledit substrat. Cette électrode inférieure est revêtue d'une couche photosensible, typiquement constituée d'une diode P-I-N, N-I-P, P-I, N-I, I-P ou I-N, réalisée en silicium amorphe, l'ensemble de la matrice étant revêtue d'une électrode supérieure phototransparente, commune donc à tous les pixels de la matrice.

Les diodes sont polarisées en inverse avec une tension de quelques volts entre l'électrode supérieure et l'électrode inférieure.

Ainsi, lorsque la couche photosensible intrinsèque absorbe un photon, elle émet une paire électron-trou, qui diffuse vers les électrodes métalliques, respectivement inférieure et supérieure, suivant les lignes de champ imposées par ces électrodes, et les particules sont collectées puis stockées pendant une certaine durée d'intégration, et enfm comptabilisées par le circuit de lecture.

Lorsque la couche photosensible est réalisée en silicium amorphe, l'épaisseur totale des couches de détection en un tel matériau dépend en partie des longueurs d'ondes à observer et à détecter, et présente typiquement une épaisseur de l'ordre de 500 nanomètres pour une détection correcte dans le rouge, et 50 nanomètres pour ne conserver que l'absorption dans le bleu.

La couche de détection peut être gravée en bord de matrice, pour permettre de redescendre l'électrode supérieure phototransparente, et polariser celle-ci en assurant un contact direct avec un connecteur ou « plug » du circuit de lecture.

Chaque pixel de l'électrode inférieure est connecté individuellement au circuit de lecture, de manière à pouvoir l'adresser, le lire et multiplexer les informations obtenues, afin de pouvoir en constituer une image correspondant à la détection observée.

L'un des problèmes fréquemment rencontrés avec ce type de structure, réside dans les courants de fuite inter-pixels au niveau des électrodes inférieures, notamment du fait de l'apparition de différence de potentiel entre deux électrodes inférieures voisines.

Afin de surmonter cette difficulté, il a été proposé, dans le US-A-6 215 164, une structure particulière des diodes P-I-N ou N-I-P des détecteurs photo-électriques. Celles-ci adoptent un profil particulier, notamment au niveau de la couche de détection intrinsèque, obtenue par matriçage de la couche dopée inférieure, de telle sorte à ne recouvrir que le métal de l'électrode inférieure. La couche photosensible de chacun des pixels est séparée de la couche photosensible du pixel adjacent au moyen d'un oxyde, typiquement un oxyde de silicium, ou de Si₃N₄, voire une combinaison des deux, dont l'objectif réside dans la limitation de l'inter-modulation optique, qualificatif généralement retenu pour désigner le phénomène de courant de fuite inter-pixel précité.

Or le matriçage des couches sensibles présente l'inconvénient d'imposer une reprise de croissance sur chaque niveau que l'on veut matricer. Il s'avère que les problèmes inhérents à la contamination de surface et de reprise de contact, ont pour effet d'augmenter le courant à l'obscurité des détecteurs ainsi obtenus, et partant, leur sensibilité au faible éclairement.

Il a également été proposé, par exemple dans le document US-A-6 114 739, de supprimer la couche dopée inférieure en prenant soin de sélectionner correctement la qualité du contact métal-couche photosensible du type contact Schottky.

Une autre difficulté à vaincre dans le cadre de la réalisation de tels détecteurs photoélectriques réside dans le fait que l'on souhaite disposer d'un fort facteur de remplissage au niveau du détecteur proprement dit. Par voie de conséquence, l'espace inter-pixel doit être aussi réduit que possible, typiquement de l'ordre de 500 nanomètres, alors que la taille des pixels peut atteindre quelques micromètres.

Cependant, en réduisant l'espace inter-pixel, on augmente les phénomènes d'inter-modulation optique, que l'on veut justement éliminer, et à tout le moins limiter.

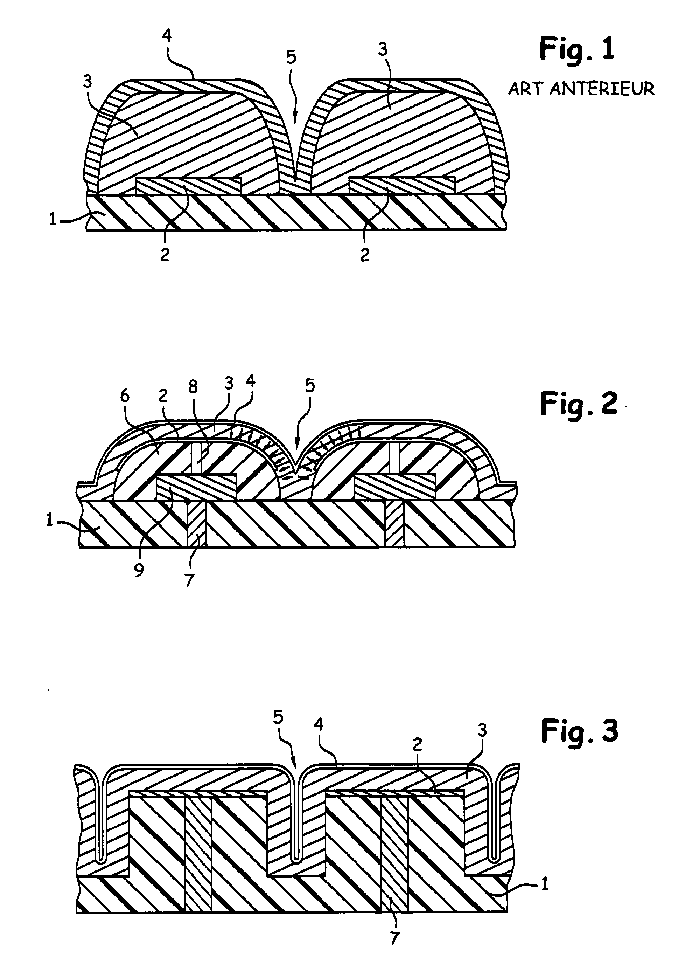

Afin de surmonter ces inconvénients, on a proposé, par exemple dans le document EP-A-0 494 694, de conférer à la couche photosensible, un profil arrondi au niveau de chacun des pixels. On a d'ailleurs représenté sur la figure 1 une vue schématique du détecteur en question. Celui comporte sur un substrat (1) isolant, notamment en oxyde de silicium, une électrode inférieure (2) par pixel, surmontée d'une couche photosensible (3), en silicium amorphe, et adoptant un profil arrondi. L'ensemble ainsi obtenu est recouvert d'une électrode supérieure phototransparente (4), qui adopte le profil de ladite couche photosensible. En revanche, ce type de matriçage présente lui aussi l'inconvénient d'imposer des reprises de croissance de couche avec les mêmes problèmes de contamination de surface que ceux évoqués dans le document US-A-6 215 164.

Pour autant, par la technologie mise en oeuvre, à savoir le montage sur circuit intégré, on observe des problèmes d'adhérence de la couche supérieure sur le circuit de lecture. Notamment dans le cadre de la mise en oeuvre de détecteurs en silicium amorphe, l'adhérence des couches contraintes, épaisses avec une forte densité d'hydrogène constitue une difficulté certaine.

Ce problème est d'autant plus aigu lorsque la couche à faire adhérer n'est pas dopée, comme c'est le cas pour les structures I-P ou I-N.

L'objet de la présente invention est de s'affranchir de ces différents inconvénients. Elle vise tout d'abord une structuration de la surface du circuit de lecture de manière à favoriser la séparation optique entre pixels (inter-modulation optique) tout en augmentant le facteur de remplissage.

L'invention propose ainsi un dispositif de détection photo-électrique comprenant, sur un substrat isolant, une matrice de détecteurs élémentaires, chacun desdits détecteurs élémentaires comprenant l'empilement d'une électrode inférieure, d'une couche d'un matériau photosensible, et d'une électrode supérieure phototransparente, ladite électrode supérieure étant commune à tous les détecteurs élémentaires, chacune des électrodes inférieures étant connectées indépendamment l'une de l'autre à un circuit de lecture au moyen d'un conducteur électrique s'étendant entre ladite électrode inférieure et ledit circuit de lecture.

Il se caractérise :
- en ce que les électrodes inférieures sont positionnées chacune sur un plot individualisé isolant, surélevé par rapport au substrat isolant ;
- et en ce que l'électrode supérieure n'est pas plane, et en outre vient s'insérer entre deux plots adjacents jusqu'à atteindre un niveau inférieur à celui des électrodes inférieures.

Ce faisant, il est possible d'aboutir à une séparation optique et donc diminuer l'inter-modulation optique sans avoir à matricer la couche de détection.

En effet, de par la structure particulière ainsi revendiquée, les lignes de champs électriques en bord de pixel sont courbées de manière à obtenir des champs électriques de directions opposées de part et d'autre du centre de la zone interpixel.

Ceci a pour conséquence d'obliger les porteurs à se diriger vers l'électrode la plus proche.

Selon l'invention, le substrat isolant est constitué d'une couche isolante déposée sur un circuit de traitement du signal.

Selon une première forme de réalisation de l'invention, les plots sont constitués chacun d'une couche supplémentaire isolante individualisée, déposée sur le substrat isolant.

Selon une autre forme de réalisation de l'invention, les plots font partie intégrante du substrat isolant.

Avantageusement, les plots de surface ont une forme élevée, de sorte que les couches photosensibles de détection de deux pixels adjacents en bord de pixel se font face quasiment verticalement, avec des polarités strictement opposées.

Selon une autre caractéristique avantageuse de l'invention, les détecteurs photoélectriques sont composés de diodes PIN, NIP, PI, NI, IP ou IN.

Par ailleurs, selon l'invention, le matériau photosensible est à base de silicium, éventuellement allié à de l'hydrogène, du germanium ou du carbone.

En outre, selon une autre caractéristique avantageuse de l'invention, l'espace entre les matériaux photosensibles de deux détecteurs voisins est réduit à deux fois l'épaisseur de l'électrode transparente, et typiquement de l'ordre de 100 nm.

L'invention vise également un procédé pour la réalisation d'un détecteur photoélectrique, du type de celui précédemment décrit.

Ce procédé pour la réalisation d'un circuit de détection constitué d'une matrice de détecteurs élémentaires déposés sur un substrat isolant et associés à un circuit de lecture, consiste :
- à réaliser pour chacun des détecteurs élémentaires, une couche de métallisation connectée au circuit de lecture par le biais de conducteurs traversant le substrat isolant ;
- à déposer sur le substrat isolant en englobant ladite couche de métallisation une couche d'un isolant électrique ;
- à réaliser un orifice au sein de ladite couche, jusqu'à atteindre la couche de métallisation, et à remplir l'orifice ainsi réalisé avec un matériau conducteur électrique, venant donc en contact électrique avec ladite couche de métallisation ;
- à déposer une électrode, destinée à devenir une électrode inférieure sur la surface supérieure de la couche isolante, ladite électrode étant en contact électrique avec le conducteur électrique ;
- à déposer une couche de matériau photosensible sur l'ensemble de la matrice ainsi réalisée, épousant sensiblement la forme de chacun des ensembles élémentaires constitués par la couche isolante et l'électrode inférieure ;
- à déposer une seule électrode supérieure phototransparente sur l'empilement ainsi réalisé, venant elle aussi épouser la forme des plots isolants, de telle sorte qu'elle descende à un niveau inférieur au niveau des électrodes inférieures.

L'invention vise également un autre procédé pour la réalisation de tels détecteurs photo-électriques.

Ce procédé pour la réalisation d'un circuit de détection constitué d'une matrice de détecteurs élémentaires déposés sur un substrat isolant et associés à un circuit de lecture, consiste :
- à déposer une couche métallique conductrice, et à la connecter par le biais d'un conducteur au circuit de lecture ;
- à réaliser une lithographie et une gravure de cette couche métallique, de telle sorte à réaliser des électrodes inférieures individualisées ;
- à réaliser une gravure profonde au sein du substrat isolant ;
- puis à déposer la couche photosensible, y compris au niveau de la gravure du substrat isolant, de telle sorte que la couche photosensible épouse le profil particulier ainsi réalisé ;
- et enfin, à déposer l'électrode supérieure phototransparente, y compris au niveau de la gravure de la couche de passivation, de telle sorte que ladite électrode supérieure vienne s'insérer dans l'interstice interpixel, afin qu'elle descende à un niveau inférieur au niveau de celui de l'électrode inférieure.

La manière de réaliser l'invention et les avantages qui en découlent ressortiront mieux des exemples de réalisation qui suivent, donnés à titre indicatif et non limitatif à l'appui des figures annexées.
La figure 1 est, ainsi que déjà précisé, une représentation schématique d'un détecteur photoélectrique conforme à l'art antérieur.
La figure 2 est une représentation schématique en section d'un détecteur photoélectrique conforme à une première forme de réalisation de l'invention.
La figure 3 est une vue analogue de la figure 2 selon une autre forme de réalisation de l'invention.

On a donc représenté en relation avec la figure 2, le détecteur photoélectrique conforme à l'invention. Afin de simplifier la représentation schématique, le circuit de lecture n'a pas été représenté sur cette figure. Par ailleurs, les différentes références numériques correspondant à des éléments ou des composants identiques à ceux de l'art antérieur ont été conservées.

Conformément à l'invention, le détecteur photoélectrique comporte pour chaque pixel tout d'abord, une couche de métallisation (9), d'épaisseur relativement importante, typiquement 1µm, connectée par le biais d'un conducteur ou « plug » (7) au circuit de lecture.

Cette couche de métallisation (9) est ensuite englobée dans un dépôt d'isolant (6), tel qu'un oxyde de silicium, un nitrure de silicium, un oxynitrure de silicium, ou toute combinaison de ceux-ci. Ce dépôt d'isolant (6) vient donc au contact du silicium du support isolant (1), et constitue un plot de forme bombée, ainsi qu'on peut bien l'observer sur la figure 2. Ce dépôt (6) peut être réalisé par CVD (chemical vapor deposition) assistée par plasma à basse température (400°C).

Une fois le plot (6) réalisé, un orifice est ménagé à partir de la surface supérieure dudit plot, jusqu'à atteindre la couche de métallisation (9). Cet orifice est comblé par un matériau conducteur électrique (8), celui-ci venant au contact avec la couche de métallisation (9).

L'électrode inférieure (2) du pixel est alors déposée sur la surface supérieure du plot (6), par exemple par pulvérisation cathodique. Cette électrode inférieure d'épaisseur relativement faible, typiquement 50 nanomètres, descend de part et d'autre du plot (6) le plus loin possible, sans pour autant atteindre la base du plot au contact avec le substrat (1).

Il est ensuite procédé au dépôt de la diode (3), notamment en silicium amorphe du type PIN, NIP, NI, PI, IN ou IP.

Ainsi qu'on peut bien l'observer sur la figure 2, cette couche en silicium amorphe épouse les contours des différents plots (6) et vient en outre combler l'interstice inter-pixel (5) entre deux plots adjacents.

On procède ensuite au dépôt d'une seule électrode supérieure (4) pour l'ensemble des pixels du détecteur, cette électrode supérieure étant phototransparente, notamment réalisée en oxyde d'indium et d'étain (ITO).

Selon une caractéristique de l'invention, l'électrode supérieure (4) vient également s'insérer dans l'espace inter-pixel (5) entre deux plots adjacents, et atteint notamment un niveau inférieur au niveau atteint par l'électrode inférieure (2).

Ce faisant, on observe que les lignes de champs électriques au niveau de la zone inter-pixel (5) sont opposées, obligeant ainsi les porteurs à se diriger vers l'électrode inférieure la plus proche. On a par ailleurs matérialisé une partie de ces lignes de champ au niveau de la figure 2 illustrant ainsi le résultat obtenu.

Selon une caractéristique avantageuse de l'invention, la distance de séparation entre les deux matériaux photosensibles de deux pixels adjacents est voisine de deux fois l'épaisseur de l'électrode supérieure phototransparente (4) (100 nanomètres pour la détection du visible 400 - 800 nm), contribuant à limiter les phénomènes d'inter-modulation optique. La zone de détection d'un pixel se rapproche ainsi au maximum de celle du pixel voisin : les électrons produits par les photons sont confinés dans l'un ou l'autre pixel. La séparation optique des pixels est donc améliorée.

Parallèlement, le profil bombé c'est à dire sans angle aigu des plots (6) et corollairement de l'électrode inférieure (2) permet de limiter le courant d'obscurité, et partant d'augmenter la dynamique du système de détection ainsi réalisé.

Selon une variante de l'invention représentée en figure 3, il est cependant possible de ne pas mettre en oeuvre une telle forme bombée de l'électrode inférieure.

Dans cette forme de réalisation, il est tout d'abord procédé par voie traditionnelle au dépôt d'une couche métallique sur le substrat isolant (1), ladite couche étant connectée au circuit de lecture par le biais de conducteurs ou « plugs » (7).

Il est alors réalisé une lithographie et une gravure de cette couche métallique, de telle sorte à constituer les électrodes inférieures (2). Puis une gravure profonde est réalisée au sein du substrat isolant (1).

On procède alors au dépôt d'une couche photosensible (3), destinée à constituer la diode de détection, sur l'ensemble ainsi réalisé, y compris au niveau de la gravure du substrat isolant, épousant ainsi le profil particulier ainsi réalisé.

L'électrode supérieure (4) phototransparente est alors déposée, et vient s'insérer dans l'espace inter-pixel (5), et dans laquelle on observe qu'elle descend au sein dudit espace à un niveau nettement inférieur à celui de l'électrode inférieure (2), permettant ainsi, comme pour la forme de réalisation décrite en liaison avec la figure 2, de réduire les phénomènes d'inter-modulation optique.

Dans l'exemple décrit, la hauteur des parois inter-pixels est relativement importante, de l'ordre du µm. Néanmoins, il est possible d'envisager une pente plus douce à ce niveau, réalisée soit par gravure soit par dépôt. Dans ce cas encore, les lignes de champs électriques sont dirigées radialement autour de chaque pixel et de sens opposé de part et d'autre de l'électrode supérieure, obligeant toujours les porteurs à se diriger vers l'électrode inférieure la plus proche.

Quel que soit le mode de réalisation retenu, il doit être souligné que la mise en oeuvre d'une telle structuration de substrat se traduit par un gain au niveau de l'adhérence mécanique des différentes couches entre elles, par des effets de relaxation locale des contraintes.

En effet, les contraintes du matériau sensible ne se propagent pas sur la totalité de la surface du dépôt, mais sont confinées à la surface de chaque pixel. L'adhérence du dépôt est améliorée par la rugosité du substrat, rugosité engendrée par la structuration de sa surface.

Il n'y a donc plus de propagation des contraintes, comme dans le cas d'une structure planarisée et l'adhérence en est ainsi fortement améliorée.

## Revendications

1. Dispositif de détection photo-électrique comprenant, sur un substrat isolant (1), une matrice de détecteurs élémentaires, chacun desdits détecteurs élémentaires comprenant l'empilement d'une électrode inférieure (2), d'une couche d'un matériau photosensible (3), et d'une électrode supérieure phototransparente (4), ladite électrode supérieure étant commune à tous les détecteurs élémentaires, chacune des électrodes inférieures (2) étant connectées indépendamment l'une de l'autre à un circuit de lecture au moyen d'un conducteur électrique s'étendant entre ladite électrode inférieure et ledit circuit de lecture, ***caractérisé :***
- **en ce que** les électrodes inférieures (2) sont positionnées chacune sur un plot individualisé isolant (6), surélevé par rapport au substrat isolant (1) ;
- et **en ce que** l'électrode supérieure (4) n'est pas plane, et en outre vient s'insérer entre deux plots (6) adjacents jusqu'à atteindre un niveau inférieur à celui des électrodes inférieures.

2. Dispositif de détection photo-électrique selon la revendication 1, ***caractérisé* en ce que** le substrat isolant (1) est constitué par une couche en matériau isolant déposée sur un circuit de traitement du signal.

3. Dispositif de détection photo-électrique selon l'une des revendications 1 et 2, ***caractérisé* en ce que** les plots (6) sont constitués chacun d'une couche supplémentaire isolante individualisée, déposée sur le substrat isolant (1).

4. Dispositif de détection photo-électrique selon l'une des revendications 1 et 2, ***caractérisé* en ce que** les plots (6) font partie intégrante du substrat isolant (1).

5. Dispositif de détection photo-électrique selon l'une des revendications 1 à 4, ***caractérisé* en ce que** les plots (6) ont une forme élevée, de sorte que les couches photosensibles de détection (3) de deux pixels adjacents en bord de pixel se font face quasiment verticalement, avec des polarités strictement opposées.

6. Dispositif de détection photo-électrique selon l'une des revendications 1 à 5, ***caractérisé* en ce que** les détecteurs photoélectriques sont composés de diodes PIN, NIP, PI, NI, IP ou IN.

7. Dispositif de détection photo-électrique selon l'une des revendications 1 à 5, ***caractérisé* en ce que** le matériau photosensible (3) est réalisé à base de silicium.

8. Dispositif de détection photo-électrique selon l'une des revendications 1 à 5, ***caractérisé* en ce que** le matériau photosensible (3) est réalisé à base de silicium allié à de l'hydrogène, du germanium ou du carbone.

9. Procédé pour la réalisation d'un circuit de détection constitué d'une matrice de détecteurs élémentaires déposés sur un substrat isolant (1) et associés à un circuit de lecture, ***caractérisé* en ce qu'**il consiste:
- à réaliser pour chacun des détecteurs élémentaires, une couche de métallisation (9) connectée au circuit de lecture par le biais de conducteurs traversant le substrat isolant ;
- à déposer sur le substrat isolant en englobant ladite couche de métallisation (9) une couche d'un matériau isolant électrique (6) constituant plot ;
- à réaliser un orifice au sein de ladite couche (6), jusqu'à atteindre la couche de métallisation (9), et à remplir l'orifice ainsi réalisé avec un matériau conducteur électrique (8), venant donc en contact électrique avec ladite couche de métallisation (9) ;
- à déposer une électrode (2), destinée à devenir une électrode inférieure sur la surface supérieure de la couche isolante (6), ladite électrode étant en contact électrique avec le conducteur électrique (8) ;
- à déposer une couche de matériau photosensible (3) sur l'ensemble de la matrice ainsi réalisée, épousant sensiblement la forme de chacun des ensembles élémentaires constitués par la couche isolante et l'électrode inférieure ;
- à déposer une seule électrode supérieure phototransparente (4) sur l'empilement ainsi réalisé, venant elle aussi épouser la forme des plots isolants (6), de telle sorte qu'elle descende à un niveau inférieur au niveau des électrodes inférieures au niveau des zones inter-détecteurs (5) ainsi ménagées.

10. Procédé pour la réalisation d'un circuit de détection constitué d'une matrice de détecteurs élémentaires déposés sur un substrat isolant (1) et associés à un circuit de lecture, ***caractérisé* en ce qu'**il consiste :
• à déposer une couche métallique conductrice (2), et à la connecter par le biais d'un conducteur (7) au circuit de lecture ;
• à réaliser une lithographie et une gravure de cette couche métallique, de telle sorte à réaliser des électrodes inférieures individualisées (2);
• à réaliser une gravure profonde au sein du substrat isolant ;
• puis à déposer une couche photosensible (3), y compris au niveau de la gravure du substrat isolant, de telle sorte que la couche photosensible épouse le profil particulier ainsi réalisé ;
• et enfm, à déposer une seule électrode supérieure phototransparente (4), y compris au niveau de la gravure du substrat isolant, de telle sorte que ladite électrode supérieure vienne s'insérer dans l'espace interpixel (5), afin qu'elle descende à un niveau inférieur au niveau de celui de l'électrode inférieure (2).

## Claims

1. Photoelectric detection device comprising a matrix of elementary detectors on an insulating substrate (1), each of said elementary detectors comprising a stack consisting of a lower electrode (2), a layer of a photosensitive material (3) and a phototransparent upper electrode (4), said upper electrode being common to all the elementary detectors, each of the lower electrodes (2) being connected independently of one another to a sense circuit by means of an electric conductor extending between said lower electrode and said sense circuit, **characterized:**
- **in that** the lower electrodes (2) are each positioned on an individualized insulating zone (6) which is elevated with respect to the insulating substrate (1);
- and **in that** the upper electrode (4) is not flat and is furthermore inserted between two adjacent zones (6) until it reaches a level below that of the lower electrodes.

2. Photoelectric detection device according to claim 1, **characterized in that** the insulating substrate (1) consists of a layer of insulating material deposited on a signal processing circuit.

3. Photoelectric detection device according to one of claims 1 and 2, **characterized in that** the zones (6) each consist of an individualized additional insulating layer deposited on the insulating substrate (1).

4. Photoelectric detection device according to one of claims 1 and 2, **characterized in that** the zones (6) form an integral part of the insulating substrate (1).

5. Photoelectric detection device according to one of claims 1 to 4, **characterized in that** the zones (6) have a raised shape, so that the photosensitive detection layers (3) of two adjacent pixels face one another substantially vertically at the pixel edge, with strictly opposite polarities.

6. Photoelectric detection device according to one of claims 1 to 5, **characterized in that** the photoelectric detectors are composed of PIN, NIP, PI, NI, IP or IN diodes.

7. Photoelectric detection device according to one of claims 1 to 5, **characterized in that** the photosensitive material (3) is based on silicon.

8. Photoelectric detection device according to one of Claims 1 to 5, **characterized in that** the photosensitive material (3) is based on silicon alloyed with hydrogen, germanium or carbon.

9. Method for the production of a detection circuit consisting of a matrix of elementary detectors deposited on an insulating substrate (1) and associated with a sense circuit, **characterized in that** it consists:
- in producing a metallization layer (9) for each of the elementary detectors, which is connected to the sense circuit by means of conductors passing through the insulating substrate;
- in depositing a layer of an electrically insulating material (6) constituting a zone on the insulating substrate, so as to enclose the said metallization layer (9);
- in producing a hole in the said layer (6) until it reaches the metallization layer (9), and in filling the hole produced in this way with an electrically conductive material (8) which therefore comes into electrical contact with the said metallization layer (9);
- in depositing an electrode (2) intended to become a lower electrode on the upper surface of the insulating layer (6), the said electrode being in electrical contact with the electrical conductor (8);
- in depositing a layer of photosensitive material (3) on all of the matrix produced in this way, which substantially follows the shape of each of the elementary assemblies consisting of the insulating layer and the lower electrode;
- in depositing a single phototransparent upper electrode (4) on the stack produced in this way, which in turn also follows the shape of the insulating zones (6), so that it descends to a level below the level of the lower electrodes in the inter-detector regions (5) formed in this way.

10. Method for the production of a detection circuit consisting of a matrix of elementary detectors deposited on an insulating substrate (1) and associated with a sense circuit, **characterized in that** it consists:
- in depositing a conductive metal layer (2) and in connecting it to the sense circuit by means of a conductor (7);
- in carrying out lithography and etching of this metal layer, so as to produce individualized lower electrodes (2);
- in carrying out deep etching within the insulating substrate;
- then in depositing a photosensitive layer (3), including where the insulating substrate has been etched, so that the photosensitive layer follows the particular profile produced in this way;
- and lastly in depositing a single phototransparent upper electrode (4), including where the insulating substrate has been etched, so that the said upper electrode is inserted into the inter-pixel space (5) in order that it descend to a level below that of the lower electrode (2).

## Patentansprüche

1. Photoelektrische Sensorvorrichtung, die auf einem isolierenden Substrat (1) eine Matrix aus Einzelsensoren umfasst, wobei ein jeder der Einzelsensoren die Aufschichtung aus einer unteren Elektrode (2), einer Schicht aus einem lichtempfindlichen Material (3) und einer oberen lichtdurchlässigen Elektrode (4) umfasst, wobei die obere Elektrode allen Einzelsensoren gemein ist, wobei eine jede der unteren Elektroden (2) unabhängig voneinander mit einem Leseschaltkreis verbunden ist, und zwar mittels eines elektrischen Leiters, der sich zwischen der unteren Elektrode und dem Leseschaltkreis erstreckt, **dadurch gekennzeichnet:**
- **dass** die unteren Elektroden (2) jeweils auf einem individualisierten isolierenden Höcker (6) positioniert sind, der in Bezug auf das isolierenden Substrat (1) erhöht ist;
- und **dass** die obere Elektrode (4) nicht eben ist und sich außerdem zwischen zwei benachbarte Höcker (6) einfügt, bis sie eine Ebene erreicht, die unter der Ebene der unteren Elektroden liegt.

2. Photoelektrische Sensorvorrichtung nach Anspruch 1, **dadurch gekennzeichnet, dass** das isolierende Substrat (1) von einer Schicht aus isolierendem Material gebildet ist, die auf einem Schaltkreis zur Signalverarbeitung abgelagert ist.

3. Photoelektrische Sensorvorrichtung nach einem der Ansprüche 1 und 2, **dadurch gekennzeichnet, dass** die Höcker (6) jeweils von einer zusätzlichen individualisierten Isolierschicht gebildet sind, die auf dem isolierenden Substrat (1) abgelagert ist.

4. Photoelektrische Sensorvorrichtung nach einem der Ansprüche 1 und 2, **dadurch gekennzeichnet, dass** die Höcker (6) einen Grundbestandteil des isolierenden Substrats (1) bilden.

5. Photoelektrische Sensorvorrichtung nach einem der Ansprüche 1 bis 4, **dadurch gekennzeichnet, dass** die Höcker (6) eine erhöhte Form haben, so dass die lichtempfindlichen Sensorschichten (3) von zwei benachbarten Pixeln am Pixelrand quasi vertikal gegenüberliegen, mit streng entgegengesetzten Polaritäten.

6. Photoelektrische Sensorvorrichtung nach einem der Ansprüche 1 bis 5, **dadurch gekennzeichnet, dass** die photoelektrischen Sensoren von PIN-, NIP-, PI-, NI-, IP- oder IN-Dioden gebildet sind.

7. Photoelektrische Sensorvorrichtung nach einem der Ansprüche 1 bis 5, **dadurch gekennzeichnet, dass** das lichtempfindliche Material (3) auf der Basis von Silizium gefertigt ist.

8. Photoelektrische Sensorvorrichtung nach einem der Ansprüche 1 bis 5, **dadurch gekennzeichnet, dass** das lichtempfindliche Material (3) auf der Basis von Silizium, in Verbindung mit Wasserstoff, Germanium oder Kohlenstoff gefertigt ist.

9. Verfahren zur Herstellung eines Sensorschaltkreises, der von einer Matrix aus Einzelsensoren gebildet ist, die auf einem isolierenden Substrat (1) abgelagert und einem Leseschaltkreis zugeordnet sind, **dadurch gekennzeichnet, dass** es darin besteht:
- für einen jeden der Einzelsensoren eine Metallisierungsschicht (9) auszubilden, die mittels das isolierende Substrat durchquerenden Leitern mit dem Leseschaltkreis verbunden ist;
- auf dem isolierenden Substrat unter Umschließen der Metallisierungsschicht (9) eine einen Höcker bildende Schicht aus einem elektrischen Isolator (6) abzulagern;
- eine Öffnung innerhalb der Schicht (6) auszubilden, bis die Metallisierungsschicht (9) erreicht ist, und die so ausgebildete Öffnung mit einem elektrisch leitenden Material (8) zu füllen, das folglich in elektrischen Kontakt mit der Metallisierungsschicht (9) gelangt;
- eine Elektrode (2) abzulagern, die dazu bestimmt ist, eine untere Elektrode auf der Oberseite der Isolierschicht (6) zu werden, wobei die Elektrode in elektrischem Kontakt mit dem elektrischen Leiter (8) ist;
- eine Schicht aus lichtempfindlichem Material (3) auf der gesamten, so ausgebildeten Matrix abzulagern, die im Wesentlichen die Form eines jeden der durch die Isolierschicht und die untere Elektrode gebildeten Einzelkomplexe annimmt;
- auf der so gebildeten Aufschichtung eine einzige obere lichtdurchlässige Elektrode (4) abzulagern, die ebenfalls die Form der isolierenden Höcker (6) annimmt, so dass sie auf eine Ebene hinunterreicht, die unter der Ebene der unteren Elektroden im Bereich der so realisierten, zwischen den Sensoren gelegenen Zonen (5) liegt.

10. Verfahren zur Herstellung eines Sensorschaltkreises, der von einer Matrix aus Einzelsensoren gebildet ist, die auf einem isolierenden Substrat (1) abgelagert und einem Leseschaltkreis zugeordnet sind, **dadurch gekennzeichnet, dass** es darin besteht:
• eine leitende Metallschicht (2) abzulagern und diese mittels eines Leiters (7) mit dem Leseschaltkreis zu verbinden;
• eine Lithographie und eine Ätzung dieser Metallschicht durchzuführen, so dass individualisierte untere Elektroden (2) ausgebildet werden;
• eine Tiefätzung innerhalb des isolierenden Substrats durchzuführen;
• anschließend eine lichtempfindliche Schicht (3), einschließlich im Bereich der Ätzung des isolierenden Substrats abzulagern, so dass die lichtempfindliche Schicht das so realisierte besondere Profil annimmt;
• und schließlich eine einzige obere lichtdurchlässige Elektrode (4), einschließlich im Bereich der Ätzung des isolierenden Substrats abzulagern, so dass sich die obere Elektrode in den zwischen den Pixeln befindlichen Zwischenraum (5) einfügt, damit sie auf eine Ebene hinunterreicht, die unter der Ebene der unteren Elektrode (2) liegt.
